(19) Europäisches Patentamt / European Patent Office / Office européen des brevets

(11) **EP 2 464 020 A1**

(12) **EUROPEAN PATENT APPLICATION**

(43) Date of publication:
**13.06.2012 Bulletin 2012/24**

(51) Int Cl.:
***H03M 13/29*** (2006.01) ***H03M 13/11*** (2006.01)

(21) Application number: **11179032.5**

(22) Date of filing: **26.08.2011**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **11.12.2010 DE 102010054228**

(71) Applicant: **Deutsches Zentrum für Luft- und
Raumfahrt e.V.
51147 Köln (DE)**

(72) Inventor: **Liva, Gianluigi
81243 München (DE)**

(74) Representative: **von Kreisler Selting Werner
Deichmannhaus am Dom
Bahnhofsvorplatz 1
50667 Köln (DE)**

(54) **Method of transmitting data**

(57) The invention is related to a Method of transmitting data from a transmitter to a receiver. According to the invention data is encoded by an encoder on the transmitter side and decoded by a decoder on the receiver side. Data is encoded and decoded using a turbo-code, whereby encoding takes places by a parallel concatenation of at least two convolutional codes. According to the invention the symbols used as input for the at least two convolutional codes for encoding are taken from a Galois field of the order >2.

Fig.2

**Description**

The Invention is related to a method of transmitting data from a transmitter to a receiver.

It is known from the state of the art to use forward error correction (FEC) schemes in order to recover lost or corrupted data packets. Among the most powerful error correcting codes turbo codes were proposed in C. Berrou, A. Glavieux, and P. Thitimajshima, "Near Shannon limit error-correcting coding and decoding :Turbo Codes", in Proc. IEEE International Conference on Communications, Geneva Switzerland, May 1993.

Turbo codes allow operating within 1 dB from theoretical limits, down to moderate-short packet lengths (few hundred bits). The best known turbo codes are discussed in: C. Douillard and C. Berrou, "Turbo codes with rate-m/(m+1) constituent convolutional codes," IEEE Transactions on Communications, vol. 53, no. 10, pp. 1630-1638, 2005.

It is an object of the present invention to provide for a method of transmitting data leading to a lower channel erasure rate (CER) compared to a given signal to noise ratio (SNR).

According to the invention this object is achieved by the features of claim one.

According to the invention data is encoded by an encoder on the transmitter side and decoded by a decoder on the receiver side. Data is encoded and decoded using a turbo-code, whereby encoding takes places by a parallel concatenation of at least two convolutional codes. According to the invention the symbols used as input for the at least two convolutional codes for encoding are taken from a Galois field of the order >2.

Preferably Galois fields of the order >64 are used.

It is preferred that each of the at least convolutional codes for encoding uses exactly one memory cell which is concatenated by an interleaver with the exactly one memory cell (containing 1 Galois field symbol) of the respectively other convolutional code. The memory cell can be for example a flip flop (containing 1 Galois field symbol) used in the convolutional encoder. Using exactly one memory cell allows to keep complexity low, so that decoding can be performed via fast Hadamard or FFT transforms. In other words only one past Galois field code symbol is kept in the convolutional codes memory according to the last mentioned feature. It is further preferred that time variant convolutional codes are used for encoding. Variation over time can be achieved for example by multiplying the output of the exactly one memory cell of each convolutional code with a coefficient changing over time. The coefficient used by the convolutional encoder can for example vary at each clock. This helps to introduce further randomness to the code, thus leading to an improved turbo code.

In a preferred embodiment the transmitted data encoded by the turbo code is decodable as a non-binary LDPC code from a Galois field of the order >2. This feature allows for a faster decoding. Instead of being decoded by a non-binary LDPC decoder, decoding can also take place by using a turbo decoder.

When using an LDPC decoder for decoding the parity check matrix of the LDPC code can be partitioned as follows:

$$\mathbf{H} = \begin{bmatrix} \tilde{\mathbf{I}} & \mathbf{P}^{(1)} & \mathbf{0} \\ \tilde{\mathbf{\Pi}} & \mathbf{0} & \mathbf{P}^{(1)} \end{bmatrix}$$

I is a K x K matrix with non-zero entries only on the main diagonal (pseudo-identity matrix). More specially: $\tilde{i}_{j,l} = g_j^{(1)}$ for j = l, otherwise $\tilde{i}_{j,l} = 0$. $\tilde{\Pi}$ is a K x K matrix with non-0 entries only for $\tilde{\pi}_{n(j),j}$, $\forall j \in (1, K)$. In particular $\tilde{\pi}_{j,n(j),} = g_j^{(2)}$, $\forall j \in (1, k)$. Thus, $\tilde{\Pi}$ can be described as the product between a permutation matrix and a pseudo- identity matrix with diagonal coefficients $g_0^{(2)}$, $g_1^{(2)}$, ... $g_{k-1}^{(2)}$, with $\Pi$ (j) being the permutation function.

Both $\tilde{P}^{(1)}$, $\tilde{P}^{(2)}$ are double diagonal matrices with from

$$\tilde{\mathbf{P}}^{(z)} = \begin{bmatrix} 1 & 0 & 0 \ldots & 0 & f_0^{(z)} \\ f_1^{(z)} & 1 & 0 \ldots & 0 & 0 \\ 0 & f_2^{(z)} & 1 \ldots & 0 & 0 \\ \vdots & \vdots & \vdots & \ddots & \vdots & \vdots \\ 0 & 0 & 0 \ldots & 1 & 0 \\ 0 & 0 & 0 \ldots & f_{K-1}^{(z)} & 1 \end{bmatrix}, \qquad z = 1, 2.$$

Thus the partition of the parity check matrix of the LDPC code leads to protograph as follows:

$$\mathbf{B} = \begin{bmatrix} 1 & 2 & 0 \\ 1 & 0 & 2 \end{bmatrix}$$

Preferred embodiments of the invention are now described in relation to the following figures.

Figure 1 shows an example of an encoder structure used in the inventive method.

Figure 2 shows the performance of a turbo code according to the invention compared to a duo-binary turbo code according to the state of the art.

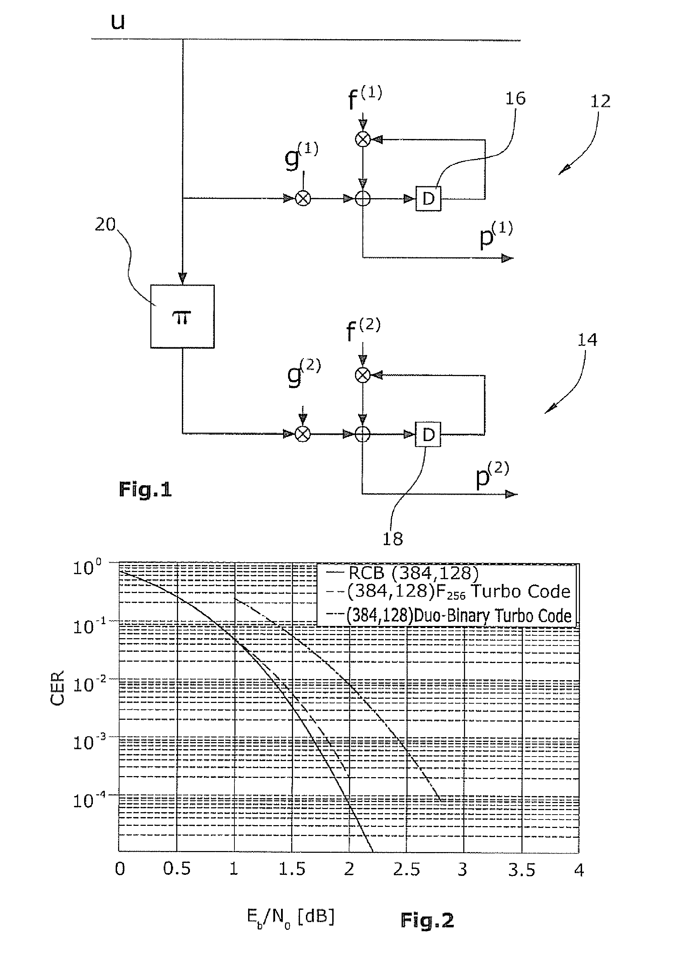

As can be seen in figure 1 the upper part represents the first convolutional encoder 12 using exactly one memory cell 16 whereby in the lower part of the figure the second convolutional encoder 14 uses exactly one memory cell 18. The two encoders 12, 14 are concatenated by the interleaver 20. The sequences g(1), g(2), f(1) and f(2) represent the time varying coefficients used at the encoder side.
Thanks to this construction this codes have a parity check matrix that is structured and sparse, in the form:

$$\mathbf{H} = \begin{bmatrix} \tilde{\mathbf{I}} & \mathbf{P}^{(1)} & \mathbf{0} \\ \tilde{\Pi} & \mathbf{0} & \mathbf{P}^{(1)} \end{bmatrix}$$

This matrix can be described by the base matrix:

$$B = \begin{bmatrix} 1 & 2 & 0 \\ 1 & 0 & 2 \end{bmatrix}$$

A turbo code on a Galois field of order 256 according to the method proposed in this application has been compared to the duo-binary turbo code of the DVB-RCS standard. The results are shown in figure 2 whereby the performance gain s remarkable (~0,7 dB at CER $10^{-4}$).

**Claims**

1.  Method of transmitting data from a transmitter to a receiver,
    whereby data is encoded by an encoder on the transmitter side and decoded by a decoder on the receiver side,
    whereby data is encoded and decoded using a turbo-code
    whereby encoding takes places by a parallel concatenation of at least two convolutional codes,
    **characterized in that**
    the symbols used as input for the at least two convolutional codes for encoding are taken from a Galois field of the order > 2.

2.  Method of transmitting data according to claim 1, **characterized in that** each of the at least two convolutional codes for encoding uses exactly one memory cell, which is concatenated by an interleaver with the exactly one memory cell of the respectively other convolutional code.

3.  Method of transmitting data according to claim 1 or 2, **characterized in that** time variant convolutional codes are used for encoding.

4.  Method of transmitting data according to claim 3, **characterized in that** variation over time is achieved by multiplying the output of the exactly one memory cell of each convolutional code with a coefficient changing over time.

5.  Method of transmitting data according to claim 1 to 4, **characterized in that** the transmitted data encoded by the turbo code is decodable as a non-binary low density parity check code (LDPC-code) from a Galois field of the order >2.

6.  Method of transmitting data according to claim 5, **characterized in that** the parity check matrix of the Turbo Code can be partitioned as follows:

$$H = \begin{bmatrix} \tilde{I} & P^{(1)} & 0 \\ \tilde{\Pi} & 0 & P^{(1)} \end{bmatrix}$$

whereby

I is a K x K matrix with non-zero entries only on the main diagonal (pseudo-identity matrix). More specially: $\tilde{i}_{j,l}=g_j^{(1)}$ for j = l, otherwise $\tilde{i}_{j,l} = 0$.

$\tilde{\Pi}$ is a K x K matrix with non-0 entries only for $\tilde{\pi}_{n(j),j}$, $\forall j \in (1, K)$. In particular $\tilde{\pi}_{j,n(j),} = g_j^{(2)}$, $\forall j \in (1, K)$. Thus, $\tilde{\Pi}$ can

be described as the product between a permutation matrix $\Pi$ and a pseudo- identity matrix with diagonal coeffi-

cients $g_0^{(2)}$, $g_1^{(2)}$, ... $g_{k-1}^{(2)}$, with $\prod_{(j)}$ being the permutation function.
Both $\tilde{P}^{(1)}$, $\tilde{P}^{(2)}$ are double diagonal matrices with from

$$
\tilde{\mathbf{P}}^{(z)} = \begin{bmatrix}
1 & 0 & 0 & \ldots & 0 & f_0^{(z)} \\
f_1^{(z)} & 1 & 0 & \ldots & 0 & 0 \\
0 & f_2^{(z)} & 1 & \ldots & 0 & 0 \\
\vdots & \vdots & \vdots & \ddots & \vdots & \vdots \\
0 & 0 & 0 & \ldots & 1 & 0 \\
0 & 0 & 0 & \ldots & f_{K-1}^{(z)} & 1
\end{bmatrix}, \qquad z = 1, 2.
$$

**7.** Method of transmitting data according to claim 6, **characterized in that** the partition of the parity check matrix of the LDPC-Code leads to a protograph as follows:

$$
\mathbf{B} = \begin{bmatrix}
1 & 2 & 0 \\
1 & 0 & 2
\end{bmatrix}
$$

**8.** Method of transmitting data according to claim 1 to 7, **characterized in that**, the symbols used as input for the at least two convolutional codes for encoding are taken from a Galois field of the order >64, and preferably of the order 256.

Fig.1

$E_b/N_0$ [dB]    Fig.2

Europäisches
Patentamt

European
Patent Office

Office européen
des brevets

# EUROPEAN SEARCH REPORT

Application Number

EP 11 17 9032

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CASTIÑEIRA MOREIRA J ET AL: "Trellis-hopping turbo coding", IEE PROCEEDINGS : COMMUNICATIONS, INSTITUTION OF ELECTRICAL ENGINEERS, GB, vol. 153, no. 6, 1 December 2006 (2006-12-01), pages 966-975, XP006027593, ISSN: 1350-2425, DOI: 10.1049/IP-COM:20050547 * abstract * * page 966 - page 968 * * pages 971, 974 * ----- | 1-4,8 | INV. H03M13/29 H03M13/11 |
| X | GULLIVER T A ET AL: "Rate-1/2 Component Codes for Nonbinary Turbo Codes", IEEE TRANSACTIONS ON COMMUNICATIONS, IEEE SERVICE CENTER, PISCATAWAY, NJ. USA, vol. 53, no. 9, 1 September 2005 (2005-09-01), pages 1417-1422, XP011139350, ISSN: 0090-6778, DOI: 10.1109/TCOMM.2005.855019 | 1,2,8 | |
| Y | * the whole document * ----- | 3,4 | TECHNICAL FIELDS SEARCHED (IPC) H03M H04L |
| X | CLAUDE BERROU ET AL: "The Advantages of Non-Binary Turbo Codes", PROCEEDINGS OF INFORMATION THEORY WORKSHOP- ITW 2001,, 2 September 2001 (2001-09-02), pages 61-64, XP002574519, ISBN: 978-0-7803-7119-4 | 1-3 | |
| A | * paragraph [000I] - paragraph [00II] * ----- -/-- | 4,8 | |

The present search report has been drawn up for all claims

| Place of search | Date of completion of the search | Examiner |
|---|---|---|
| The Hague | 22 February 2012 | Belardinelli, Carlo |

Europäisches
Patentamt

European
Patent Office

Office européen
des brevets

# EUROPEAN SEARCH REPORT

Application Number

EP 11 17 9032

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | WEI LIN ET AL: "Design of q-ary Irregular Repeat-Accumulate Codes", ADVANCED INFORMATION NETWORKING AND APPLICATIONS, 2009. AINA '09. INTERNATIONAL CONFERENCE ON, IEEE, PISCATAWAY, NJ, USA, 26 May 2009 (2009-05-26), pages 201-206, XP031476102, ISBN: 978-1-4244-4000-9 * the whole document * ----- | 3,4 | |
| L | GIANLUIGI LIVA ET AL: "Turbo Codes Based on Time-Variant Memory-1 Convolutional Codes over Fq", ICC 2011 - 2011 IEEE INTERNATIONAL CONFERENCE ON COMMUNICATIONS - 5-9 JUNE 2011 - KYOTO, JAPAN, IEEE, PISCATAWAY, NJ, USA, 5 June 2011 (2011-06-05), pages 1-6, XP031908241, DOI: 10.1109/ICC.2011.5962474 ISBN: 978-1-61284-232-5 * the whole document * ----- | 5-7 | |

TECHNICAL FIELDS
SEARCHED      (IPC)

The present search report has been drawn up for all claims

| Place of search | Date of completion of the search | Examiner |
|---|---|---|
| The Hague | 22 February 2012 | Belardinelli, Carlo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

    ..................................................................................

& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **C. BERROU ; A. GLAVIEUX ; P. THITIMAJSHIMA.** Near Shannon limit error-correcting coding and decoding :Turbo Codes. *Proc. IEEE International Conference on Communications,* May 1993

- **C. DOUILLARD ; C. BERROU.** Turbo codes with rate-m/(m+1) constituent convolutional codes. *IEEE Transactions on Communications,* 2005, vol. 53 (10), 1630-1638